# EUROPEAN PATENT SPECIFICATION

(11) **EP 1 517 602 B1**
(45) Date of publication and mention of the grant of the patent: **19.10.2011**
(21) Application number: 03028706.4
(22) Date of filing: 12.12.2003
(51) Int. Cl.: H05K 7/20

(54) **Cooling structure of electronic element**
Struktur zur Kühlung eines elektonischen Elementes
Structure de refroidissement d'un élement électronique

(30) Priority: 16.09.2003 KR 2003063971
(43) Date of publication of application: 23.03.2005
(73) Proprietor: HYUNDAI MOTOR COMPANY, Seoul (KR)
(72) Inventor: Choi, Kee-Hoon, Dongdaemun-gu,Seoul, 130-090 (KR)
(74) Representative: Reinhard - Skuhra - Weise & Partner GbR

(56) References cited:
- EP-A- 1 178 594
- EP-A- 1 289 011
- WO-A-00/02430
- WO-A-02/096175
- JP-A- 11 204 970
- US-A- 4 839 774

## Description

### CROSS-REFERENCE TO RELATED APPLICATIONS

This application claims priority of Korean Application No. 10-2003-0063971, filed on September 16, 2003.

### FIELD OF THE INVENTION

The present invention relates to a cooling structure of an electronic element mounted on an electronic circuit substrate and, more particularly, to a technology relating to a concentrated cooling of a particular element having a large calorific power out of electronic elements mounted on a circuit substrate.

### BACKGROUND OF THE INVENTION

Electronic circuit substrates have recently been mounted in a single package by integrating a plurality of elements. In this case, it is important that the heat-generated substrates are cooled to an optimal temperature. In particular, in order for a Code Division Multiple Access (CDMA) modem to operate under high temperature conditions for a long period of time, the cooling performance of a Power Amplifying Module (PAM) having a large calorific power out of electronic elements comprising the CDMA modem should be optimized.

EP 1 389 899 A describes a portable power amplifier, which includes portable encapsulating cases, a printed board incorporated in those encapsulating cases, and a power amplifying device mounted on this printed board. An antenna switch and an antenna are provided near the power amplifying device, which is connected to those components in a pattern. This structure improves the heat dissipation efficiency of the portable power amplifier.

WO 00/02430 A1 describes a plastic housing assembly is constructed with a non-plateable plastic wall portion, and a plateable plastic wall portion positioned abutting the non-plateable plastic wall portion. The plateable plastic wall portion has a via disposed therethrough for thermally coupling an outer surface to an inner surface. A heat-generating component is disposed coupled to the second inner surface.

US 4 839 774 A describes a data processing system, wherein the packages containing the electronic components are cooled by directing the cooling material through an array of nozzles toward the packages and components. The nozzles are fabricated in the circuit board, the flow of the coolant being the result of a difference in pressure of the coolant between the two sides of the circuit board.

JP 11 204970 A describes a electronic equipment, which is provided with a frame body having a side wall, a printed board stored in the frame body, covers an upper cover and a lower cover for covering the frame body and heat sink parts and arranged to face the external plane of the side wall by providing a space. At least a part of the heat sink part is bonded to the frame body or the covers.

### SUMMARY OF THE INVENTION

Embodiments of the present invention provide a cooling structure of an electronic element adapted to further improve the cooling performance of a particular electronic element mounted on a circuit substrate and to concurrently obtain a stable operational performance of electronic circuits for a long period of time.

In accordance with a preferred embodiment of the present invention, the cooling structure of an electronic element comprises an extended portion formed on an inner bafflement baffling an inner circuit substrate and contacted to an upper surface of a cooling object electronic element mounted at the inner circuit substrate. A plurality of through holes is formed at the inner circuit substrate underneath the PAM. A radiating plate is mounted on a baffle case encompassing an external side of the inner bafflement and the inner circuit substrate. A plurality of baffle case holes is formed underneath the baffle case.

### BRIEF DESCRIPTION OF THE DRAWINGS

For fuller understanding of the nature and objects of the present invention, reference should be made to the following detailed description taken in conjunction with the accompanying drawings in which:
Fig. 1 is a cross-sectional view for illustrating a cooling structure of an electronic element;

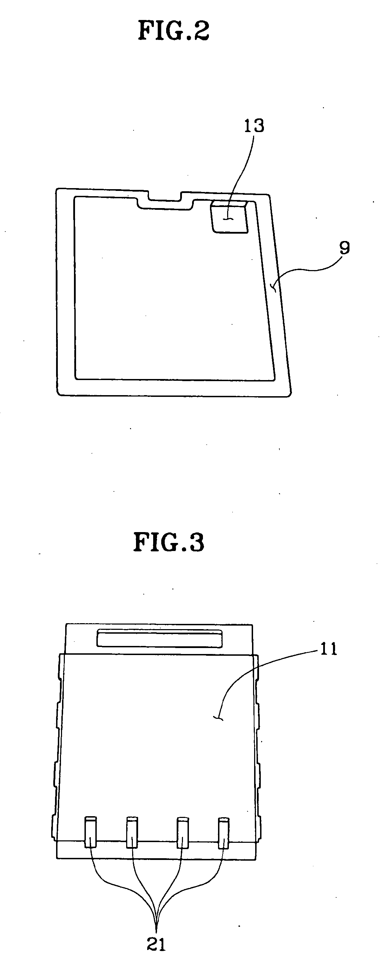

Fig. 2 is a schematic drawing for illustrating an inner bafflement and an extension thereof of Fig. 1;
Fig. 3 is a schematic drawing for illustrating baffle case holes formed underneath the baffle case of Fig. 1;
Fig. 4 illustrates a cooling surface of an external circuit substrate; and
Fig. 5 is a detailed drawing for illustrating through holes of Fig. 1.

### DETAILED DESCRIPTION OF THE PREFERRED EMBODIMENTS

The preferred embodiment of the present invention will now be described in detail with reference to the accompanying drawings.

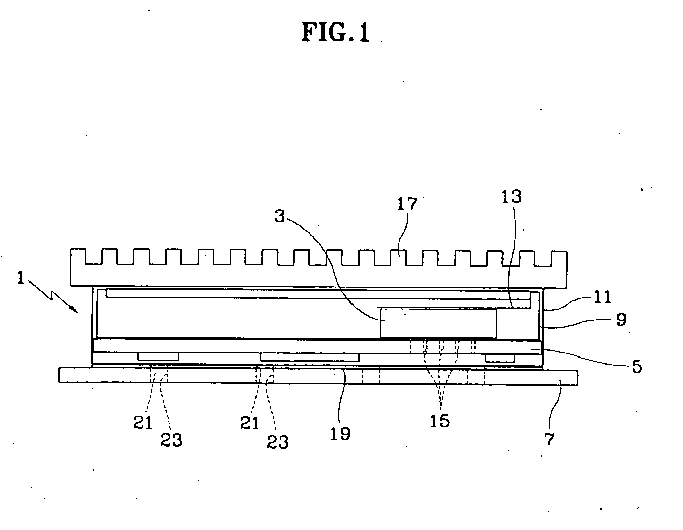

As illustrated in Fig.1, a cooling object electronic element is a PAM 3 of CDMA modem 1. The CDMA modem 1 is largely comprised of an inner circuit substrate 5 and an external circuit substrate 7. Of course, the present invention can be applied to a case of a single circuit substrate. In this case, the inner circuit substrate can be a single circuit substrate.

As shown in Fig. 1, the structure according to the embodiment of the present invention comprises: an inner bafflement 9 and a baffle case 11 for baffling an inner circuit substrate 5, the inner bafflement 9 formed with an extended portion 13 for contacting an upper surface of a PAM 3 which is a cooling object electronic element mounted at the inner circuit substrate 5; a plurality of through holes 15 at the inner circuit substrate 5 underneath the PAM 3; a radiating plate 17 mounted on the baffle case 11 encompassing an external side of the inner bafflement 9 and the inner circuit substrate 5; and a plurality of baffle case holes 21 mounted underneath the baffle case 11.

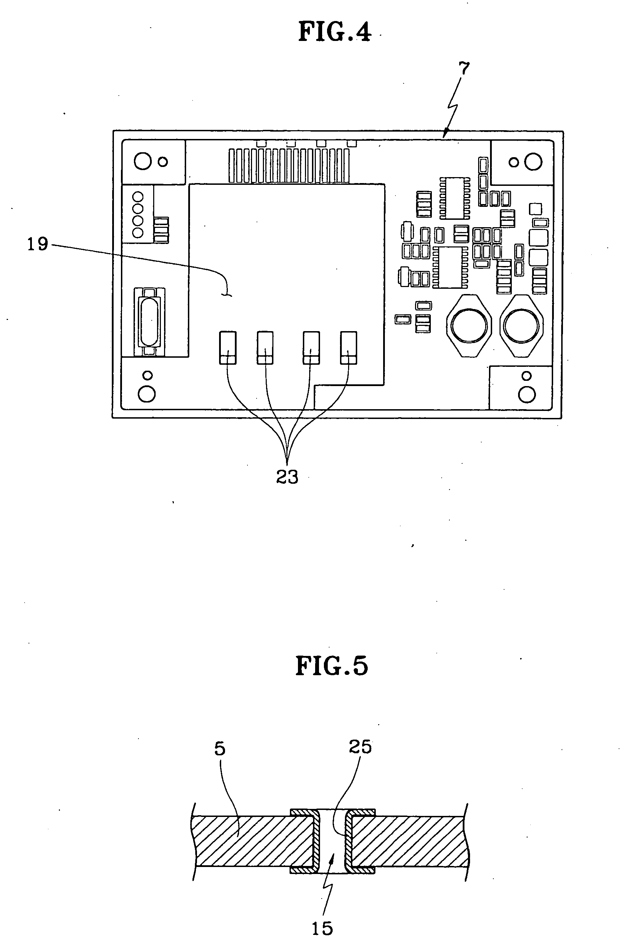

The bottom surface of the baffle case 11 contacts the upper surface of the external circuit substrate 7, where the upper surface of the external circuit substrate 7 contacting the bottom surface of the baffle case 11 is equipped with a metal cooling surface 19 as depicted in Fig. 4, and the external circuit substrate 7 is formed with a plurality of external circuit substrate holes 23 to correspondingly communicate with the baffle case holes 21 of the baffle case 11.

The metal cooling surface 19 is a flat surface made of lead formed on the external circuit substrate 7 by a Solder Masking Open process so as to be automatically formed by soldering the circuit substrate.

Next, the cooling operation of the CDMA modem having the structure thus described will be explained.

The extension of the inner bafflement 9 directly contacting the upper surface of the PAM 3 serves to swiftly discharge the heat generated from the PAM 3 by way of conduction.

Meanwhile, heat from the PAM 3 is discharged underneath the inner circuit substrate 5 via the through the plural holes 15 formed at the inner circuit substrate 5. As illustrated in Fig.5, the plural holes 15 made of metal cylinders for communicating the upper and lower sides of the inner circuit substrate 5 are used for electrically connecting the upper and lower sides of the inner circuit substrate 5 and concurrently act as media for transferring the heat generated from the electronic element thus explained.

The heat passing through the extension of the inner bafflement 9 and the through holes 15 of the inner circuit substrate 5 is emitted outside via the baffle case 11, where the heat is swiftly exhausted outside by the radiating plate 17 mounted on the baffle case 11, the baffle case holes 21 equipped at the bottom surface of the baffle case 11 and the metal cooling surface 19.

In other words, a swift heat exchange is carried out by the surrounding air by a broad cooling area formed by a plurality of fins at the radiating plate 17, and heated air formed inside the baffle case 11 is swiftly released outside via the baffle case holes 2 to thereby promote an effective cooling of the inner circuit substrate 5 and the PAM 3.

Of course, because the baffle case 11 makes contact with the metal cooling surface 19 provided at the external circuit substrate 7, heat can be also discharged outside by conduction via the metal cooling surface 19, and air heated inside the baffle case 11 passes through the baffle case 11 and the external circuit substrate 7 all together to be emitted outside.

Representative types of heat transfer for cooling reaction thus described can be explained in two ways, one of which is conduction and the other of which is convection.

Heat can be transferred via a conduction route which is formed by the PAM3-extended portion 13-inner bafflement 9-baffle case 11-radiating plate 17, and a route which is formed by the PAM 3-extended portion 13-inner bafflement 9-baffle case 11-metal cooling surface 19 of the external circuit substrate 7, while the heat can be transferred via a convection route which is formed by the PAM 3-through holes 15-baffle case holes 21-external circuit substrate holes 23.

Application of various cooling means thus described prevents the PAM 3 from deviating from the stable operating temperature, thus providing a normal operating condition at all times and, more particularly, without recourse to a fan of forced cooling means, and further prevents damage to circuits caused by inflow of dust even during a long period of use. The application allows obtainment of a stable operability for a long period of time without being affected by life of the fan itself.

As apparent from foregoing, there is an advantage in the cooling structure of an electronic element thus described according to the present invention in that a smooth heat transfer can be carried out via a variety of heat transfer routes of conduction and convention without recourse to a forced cooling means such as a fan or the like, thus improving the cooling performance of electronic elements and stabilizing the operation of electronic circuits for a long period of time.

## Claims

1. A cooling structure of an electronic element, wherein the structure comprises:
an extended portion formed on an inner bafflement (9) baffling an inner circuit substrate (5) and contacted to an upper surface of a cooling object electronic element mounted at said inner circuit substrate (5);
a plurality of through holes (15) formed through said inner circuit substrate (5) underneath said cooling object electronic element;
a radiating plate (17) mounted on a baffle case (11) encompassing an external side of said inner bafflement (9) and said inner circuit substrate (5); and
a plurality of baffle case holes (21) going through the lower wall of the baffle case (11);
**characterised in that** the structure further comprises a metal cooling surface (19) provided on an upper surface of an external circuit substrate (7) contacting the bottom surface of said baffle case; and
a plurality of external circuit substrate (7) holes (23) formed through said external circuit substrate (7) to correspondingly communicate with said baffle case holes (21) of said baffle case (11).

2. The structure as defined in claim 1,
wherein said metal cooling surface (19) is a flat surface made of lead formed on said external circuit substrate (7) by a Solder Masking Open process.

3. The structure as defined in claim 1,
wherein said cooling object electronic element is a PAM of code division multiple access (CDMA) modem

## Patentansprüche

1. Kühlstruktur eines elektronischen Elementes, wobei die Struktur aufweist:
- einen erweiterten Abschnitt, welcher auf einem inneren Leitblech (9) ausgebildet ist, welches ein inneres Schaltkreissubstrat (5) trennt, und zu einer oberen Oberfläche eines Kühlobjektes eines elektronischen Elementes kontaktiert ist, welches an dem inneren Schaltkreissubstrat (5) befestigt ist;
- eine Vielzahl von Durchgangslöchern (15), welche durch das innere Schaltkreissubstrat (5) unterhalb des Kühlobjektes des elektronischen Elements gebildet sind;
- eine Abstrahlplatte (17), welche auf einem Leitblechgehäuse (11) befestigt ist, welches eine äußere Seite des inneren Leitblechs (9) und das innere Schaltkreissubstrat (5) umfasst; und
- eine Vielzahl von Leitblechgehäuselöchern (21), welche durch die untere Wand des Leitblechgehäuses (11) gehen;
**dadurch gekennzeichnet,**
**dass** die Struktur ferner eine metallische Kühloberfläche (19) aufweist, welche auf einer oberen Oberfläche eines äußeren Schaltkreissubstrates (7) zur Verfügung gestellt ist, welche die untere Oberfläche des Leitblechgehäuses kontaktiert; und
eine Vielzahl von äußeren Schaltkreissubstratlöchern (7, 23), welche durch das äußere Schaltkreissubstrat (7) ausgebildet sind, um entsprechend mit den Leitblechgehäuselöchern (21) des Leichtblechgehäuses (11) zu kommunizieren.

2. Struktur nach Anspruch 1,
wobei die metallische Kühloberfläche (19) eine flache Oberfläche ist, welche aus Blei gemacht ist, welche auf dem äußeren Schaltkreissubstrat (7) durch einen offenen Lötstoppmaskenprozess gebildet ist.

3. Struktur nach Anspruch 1,
wobei das Kühlobjekt des elektronischen Elementes ein PAM eines Codemultiplexverfahren-(CDMA)-Modems ist.

## Revendications

1. Structure de refroidissement d'un élément électronique, la structure comprenant :
- une partie étendue formée sur un déflecteur intérieur (9) séparant un substrat de circuit interne (9) et mise en contact avec une surface supérieure d'un élément électronique à objet refroidissant, monté sur ledit substrat de circuit interne (5) ;
- une pluralité d'orifices de passage (15) formés à travers ledit substrat de circuit interne (5) au-dessous dudit élément électronique à objet refroidissant ;
- une plaque rayonnante (17) montée sur un boîtier déflecteur (11) englobant un côté externe dudit déflecteur interne (9) et dudit substrat de circuit interne (5) ; et
- une pluralité d'orifices de boîtier déflecteur (21) passant par la paroi inférieure du boîtier déflecteur (11) ;
**caractérisée en ce que** la structure comprend en outre une surface de refroidissement métallique (19) située sur une surface supérieure d'un substrat de circuit externe (7) touchant la surface inférieure dudit boîtier déflecteur ; et une pluralité d'orifices (23) de substrat de circuit externe (7) formés à travers ledit substrat de circuit externe (7) de façon à communiquer en correspondance avec lesdits orifices de boîtier déflecteur (21) dudit boîtier déflecteur (11).

2. Structure selon la revendication 1, dans laquelle ladite surface de refroidissement métallique (19) est une surface plate en plomb formée sur ledit substrat de circuit externe (7) par un procédé de masque de brasage ouvert.

3. Structure selon la revendication 1, dans laquelle l'élément électronique à objet refroidissant est un module amplificateur de puissance (PAM) d'un modem à accès multiple par répartition en code (CDMA).
